# FASCICULE DE BREVET EUROPEEN

(11) **EP 2 450 949 B1**
(45) Date de publication et mention de la délivrance du brevet: **27.04.2016**
(21) Numéro de dépôt: 11188107.4
(22) Date de dépôt: 07.11.2011
(51) Int. Cl.: H01L 23/26, H01L 23/31, B81B 7/00

(54) **Structure d'encapsulation d'un micro-dispositif comportant un matériau getter**
Einkapselungssstruktur einer Mikrovorrichtung, die ein Getter-Material umfasst
Structure for encapsulating a microdevice comprising a getter material

(30) Priorité: 09.11.2010 FR 1059248
(43) Date de publication de la demande: 09.05.2012
(73) Titulaire: Commissariat à l'Énergie Atomique et aux Énergies Alternatives, 75015 Paris (FR)
(72) Inventeur: Baillin, Xavier, 38920 CROLLES (FR); Ferrandon, Christine, 38360 SASSENAGE (FR)
(74) Mandataire: Ilgart, Jean-Christophe

(56) Documents cités:
- EP-A1- 2 141 117
- FR-A1- 2 922 202
- US-A- 4 769 345
- US-A1- 2005 085 053
- US-A1- 2006 283 546

## Description

### DOMAINE TECHNIQUE

L'invention concerne le domaine des structures d'encapsulation de micro-dispositifs comportant des matériaux getter utilisés pour absorber et/ou adsorber des gaz dans un environnement clos.

L'invention s'applique notamment à l'encapsulation de micro-dispositifs comportant un ou plusieurs microsystèmes par exemple de type MEMS (microsystèmes électromécaniques) et/ou NEMS (nanosystèmes électromécaniques) ou de type détecteur infrarouge, tels que des micro-bolomètres.

L'invention concerne plus particulièrement une structure d'encapsulation hermétique sous atmosphère contrôlée de micro-dispositifs de type MEMS résonants.

### ÉTAT DE LA TECHNIQUE ANTÉRIEURE

Certains microsystèmes tels que ceux de type MEMS et/ou NEMS, ou les micro-détecteurs infrarouge, nécessitent pour leur bon fonctionnement d'être encapsulés dans une cavité dont l'atmosphère est contrôlée (nature du gaz et pression régnant la cavité).

La technologie utilisée à ce jour pour obtenir une telle encapsulation consiste à réaliser tout d'abord ces microsystèmes collectivement sur un premier substrat (wafer) de silicium dont l'épaisseur est de plusieurs centaines de micromètres. Chacun des microsystèmes est encapsulé dans une cavité obtenue par report et scellement hermétique d'un capot, par exemple formé par un second substrat de silicium ou de verre dont l'épaisseur est également de plusieurs centaines de micromètres, sur le premier substrat. Le second substrat est pourvu de creux réalisés collectivement, et lors de l'assemblage entre les deux substrats, les microsystèmes sont disposés dans ces creux formant les cavités. Après cet assemblage, l'un des deux substrats peut être aminci, jusqu'à une épaisseur minimum d'environ 50 µm, afin de pouvoir réaliser ensuite des opérations technologiques comme par exemple la réalisation de vias à travers le substrat aminci. Le substrat non aminci sert alors de poignée mécanique pour l'assemblage.

Cet assemblage hermétique entre le premier et le second substrat et formant les cavités d'encapsulation des microsystèmes permet notamment de contrôler les fuites de gaz entre l'intérieur des cavités et l'environnement extérieur. L'ajout de getters non évaporables (NEG) dans les cavités, par exemple sous la forme de portions de matériau getter disposées dans les cavités, permet de contrôler l'atmosphère au sein des cavités.

La réalisation des portions de matériau getter nécessite la mise en oeuvre d'opérations technologiques de dépôt et de gravure par photolithographie afin de mettre en forme les portions de matériau getter en deux dimensions, dans le plan des deux substrats. Une variante peut consister à déposer le getter de manière discrète directement sous la forme souhaitée par pochoir, par l'intermédiaire d'un masque dur sur le premier substrat, à côté des microsystèmes ou sur le capot. Une seconde variante peut consister à déposer le getter par un procédé de lift-off sur un film de résine photosensible préalablement mis en forme par photolithographie. Le document US 2003/052392 A1 décrit un exemple de matériau getter discrétisé, formant plusieurs portions distinctes de matériau getter disposées dans les différentes cavités fermées par le capot.

Dans tous les cas, les étapes de mise en forme du matériau getter représentent un coût important dans la réalisation des structures d'encapsulation. De plus, la mise en oeuvre de ces étapes présente un risque vis-à-vis du matériau getter en raison de la compatibilité chimique de celui-ci avec les produits utilisés pour réaliser ces opérations de discrétisation du matériau getter.

Il est également connu de réaliser une encapsulation via le dépôt d'une ou plusieurs couches minces pour réaliser le capot, comme décrit par exemple dans le document EP 2 141 117 A1. Un matériau getter est également intégré pour former la première couche d'encapsulation. Un tel procédé a pour inconvénient d'impliquer la réalisation d'ouvertures à travers le capot pour éliminer le matériau sacrificiel sur lequel la ou les couches minces ont été déposées. De plus, dans ce procédé, c'est la face arrière (côté du matériau getter qui a été déposé contre le matériau sacrificiel) de la couche de matériau getter qui se retrouve exposée dans la cavité, ce qui ne permet pas par exemple de faire appel à une sous-couche d'ajustement de la température d'activation thermique du matériau getter. Enfin, ce procédé implique également l'exposition du matériau getter, lors de la libération de la cavité, à une ambiance gazeuse oxydante (avec une température comprise entre 250°C et 300°C) pendant plusieurs minutes, pouvant dégrader la capacité de pompage gazeux du matériau getter.

### EXPOSÉ DE L'INVENTION

Un but de la présente invention est de proposer un nouveau type de structure d'encapsulation d'un ou plusieurs micro-dispositifs, comportant un matériau getter et ne présentant pas les inconvénients des structures d'encapsulation de l'art antérieur.

Pour cela, la présente invention propose une structure d'encapsulation comportant au moins une cavité dans laquelle est disposé au moins un micro-dispositif, la cavité étant délimitée par au moins un premier substrat et au moins un second substrat solidarisé au premier substrat par l'intermédiaire d'au moins une interface de collage composée d'au moins un matériau métallique ou diélectrique, dans laquelle au moins une face principale du second substrat disposée en regard du premier substrat est recouverte par au moins une couche d'au moins un matériau getter, l'interface de collage étant disposée entre le premier substrat et la couche de matériau getter.

On entend par « recouvert » le fait que ladite face principale du second substrat disposée en regard du premier substrat est totalement ou quasi-totalement recouverte par au moins ladite couche d'au moins un matériau getter.

On propose donc une structure réalisant une encapsulation d'un ou plusieurs micro-dispositifs au niveau substrat (« Wafer Level Packaging » en anglais), c'est-à-dire dont le capot est formé par le report d'un substrat, et dans laquelle une couche de matériau getter est déposée de manière continue ou quasi-continue sur une face principale du substrat dont la fonction peut être de servir de capot.

Le second substrat peut former un capot continu, c'est-à-dire qu'il ne comporte pas de trous (ou ouvertures) réalisés à travers celui-ci, notamment à travers ses faces principales, contrairement aux structures de l'art antérieur qui comportent des capots formés par des dépôts de couches minces sur un matériau sacrificiel et dans lesquelles des ouvertures sont nécessairement réalisées à travers les capots pour éliminer ce matériau sacrificiel. Ainsi, le capot peut avoir une épaisseur supérieure ou égale à environ 50 µm.

Contrairement aux structures d'encapsulation de l'art antérieur, la couche de matériau getter se prolonge donc au niveau de l'interface de collage entre les deux substrats, ce qui présente de nombreux avantages notamment pour la réalisation de l'interface de collage qui est composée d'au moins un métal, à savoir le matériau getter.

En effet, le matériau getter, qui est un matériau métallique, est ici compatible d'un point de vue matériaux avec celui ou ceux de l'interface de collage, garantissant une bonne tenue mécanique de la structure et une bonne herméticité de la cavité formée dans la structure d'encapsulation. Le dépôt d'un métal sur le matériau getter va donner lieu à une liaison mécanique forte entre ces deux matériaux métalliques, soit par la formation de composés intermétalliques à l'interface, soit par la formation d'une solution solide métallique, soit à l'aide des forces de Van Der Waals lorsque les deux matériaux métalliques ne présentent aucune réactivité entre eux dans les conditions opératoires mises en oeuvre (dépôt et opérations ultérieures).

Une telle structure d'encapsulation ne nécessite pas la mise en oeuvre d'étapes de mise en forme du matériau getter, ce qui réduit le coût de la structure d'encapsulation.

De plus, par rapport aux structures d'encapsulation comportant des portions discrétisées de matériau getter, on augmente la surface de matériau getter exposée dans la cavité, ce qui permet d'obtenir une capacité de pompage plus importante ou, pour une même pression recherchée, un relâchement des contraintes relatives à l'obtention de la capacité de pompage requise pour obtenir cette pression.

De plus, ce procédé permet d'exposer dans la cavité la face avant de la couche de matériau getter.

Le premier substrat et le second substrat de la structure d'encapsulation peuvent avoir des épaisseurs supérieures ou égales à environ 50 µm.

Le second substrat peut former un capot.

La cavité peut être fermée hermétiquement.

La couche de matériau getter peut avoir une épaisseur comprise entre environ 100 nm et 2 µm.

L'interface de collage peut comporter au moins deux portions métalliques assemblées l'une contre l'autre. Par exemple, l'interface de collage peut comporter au moins deux portions métalliques thermocompressées, c'est-à-dire collées par thermocompression, l'une contre l'autre. La thermocompression réalisée correspond à un assemblage entre deux solides mis en contact l'un contre l'autre ou entre avec un matériau fusible intercalé entre ces deux solides, sous contrainte, par exemple sous une pression comprise entre environ 1 MPa et 90 MPa, à une température donnée (par exemple comprise entre environ 300°C et 450°C). Au moins une des deux portions métalliques peut passer à l'état liquide lors de la thermocompression.

L'interface de collage peut comporter au moins une portion diélectrique thermocompressée contre la couche de matériau getter ou contre au moins une portion métallique disposée sur la couche de matériau getter. Une partie de la couche de matériau getter peut former l'interface de collage. Dans ce cas, l'interface de collage peut comporter au moins une portion métallique et une portion diélectrique, comprenant par exemple de l'oxyde ou du nitrure de semi-conducteur (tel que du SiO₂ et/ou du SiN), thermocompressées l'une contre l'autre. L'activation thermique du getter déposé sur le second substrat, mise en oeuvre lors du procédé d'assemblage, contribue à créer une liaison getter/diélectrique lorsque la portion diélectrique est solidarisée à la couche de matériau getter.

On peut aussi concevoir une interface de collage comportant une portion métallique thermocompressée contre la couche de matériau getter. Dans ce cas, la portion métallique peut être avantageusement composée de Ti et/ou de Zr et/ou de V.

Le micro-dispositif peut être réalisé dans et/ou sur le premier substrat.

La structure d'encapsulation peut comporter en outre au moins une couche d'un matériau apte à modifier la température d'activation thermique du matériau getter, disposée entre la couche de matériau getter et ladite face principale du second substrat.

Le second substrat peut comporter au moins un trou, ou un creux, formé au niveau de ladite face principale du second substrat et pouvant délimiter au moins une paroi de la cavité.

La structure peut comporter en outre au moins un contact électrique réalisé à travers le premier substrat, formant une liaison électrique entre la cavité et une face arrière du premier substrat opposée à une autre face du premier substrat disposée en regard du second substrat, et/ou une liaison électrique entre la face arrière du premier substrat et le matériau getter via l'interface de collage.

Il est ainsi possible de réaliser un via traversant le premier substrat et qui soit relié électriquement au getter. Un tel via permet de polariser le getter qui peut ainsi jouer un rôle dans le fonctionnement du micro-dispositif ou encore de le relier électriquement à un potentiel électrique ou à la masse.

On propose également une structure d'encapsulation comportant au moins une cavité dans laquelle est disposé au moins un micro-dispositif, la cavité étant délimitée par au moins un premier substrat et au moins un second substrat solidarisé au premier substrat, dans laquelle au moins une face principale du second substrat disposée en regard du premier substrat est recouverte, par exemple totalement ou quasi-totalement, par au moins une couche d'au moins un matériau getter. L'interface de collage entre le premier substrat et le second substrat est donc formé par le matériau getter.

L'invention concerne également un procédé de réalisation d'une structure d'encapsulation d'au moins un micro-dispositif, comportant au moins les étapes suivantes :
- réalisation d'une couche d'au moins un matériau getter recouvrant, par exemple totalement ou quasi-totalement, une face principale d'un second substrat,
- réalisation d'une interface de collage composée d'au moins un matériau métallique ou diélectrique sur un premier substrat et/ou sur la couche de matériau getter,
- solidarisation du second substrat au premier substrat par l'intermédiaire de l'interface de collage, délimitant une cavité formée entre le premier substrat et le second substrat et dans laquelle est disposé le micro-dispositif, l'interface de collage étant disposée entre le premier substrat et la couche de matériau getter.

Le second substrat peut former un capot continu.

La solidarisation peut être réalisée sous atmosphère contrôlée et telle que la cavité soit fermée hermétiquement.

L'interface de collage peut être réalisée en formant au moins une première portion métallique sur la couche de matériau getter et/ou au moins une seconde portion métallique ou diélectrique sur le premier substrat, et dans lequel la solidarisation du second substrat au premier substrat peut être obtenue par la mise en oeuvre d'une thermocompression de la première portion métallique contre la seconde portion métallique ou diélectrique ou de la seconde portion métallique ou diélectrique contre la couche de matériau getter.

La thermocompression peut être directe entre la première portion et la seconde portion, ou bien réalisée par l'intermédiaire d'une brasure fusible disposée entre la première portion métallique et la seconde portion.

Toutefois, on distingue généralement la thermocompression de la brasure, car elle fait appel à des mécanismes de diffusion à l'état solide.

Dans ce cas, la première portion métallique peut être réalisée par un dépôt électrolytique d'au moins un matériau métallique sur la couche de matériau getter au cours duquel un courant apte à faire croître ledit matériau métallique peut circuler dans la couche de matériau getter. La croissance électrolytique du matériau métallique (par exemple de l'Au-Sn si l'on souhaite réaliser une brasure métallique) peut conduire à la formation d'une interface métal / métal robuste. De plus, le dépôt électrolytique du matériau métallique peut avoir une épaisseur de plusieurs microns (par exemple jusqu'à 10 µm) qui permet de définir simultanément la hauteur de la cavité et évite ainsi de réaliser au préalable un creux dans le capot.

Le procédé peut comporter en outre, préalablement à la réalisation de la couche de matériau getter, une étape de réalisation d'une couche d'un matériau apte à modifier la température d'activation thermique du matériau getter sur ladite face principale du second substrat, la couche de matériau getter pouvant être ensuite réalisée au moins sur ladite couche du matériau apte à modifier la température d'activation thermique du matériau getter. Il est également possible de réaliser deux sous-couches d'ajustement différentes adjacentes, recouvertes par un même matériau getter. Dans ce cas, le matériau getter présente deux zones de caractéristiques (capacité de pompage et température d'activation thermique) différentes. Il est alors possible d'intégrer deux getter de grande taille dans une même cavité.

Le procédé peut comporter en outre, préalablement à la réalisation de la couche de matériau getter, une étape de réalisation d'au moins un trou, ou creux, au niveau de ladite face principale du second substrat et délimitant au moins une paroi de la cavité.

Le procédé peut comporter en outre, préalablement à la solidarisation du second substrat au premier substrat, une étape de réalisation du micro-dispositif dans et/ou sur le premier substrat.

Le procédé peut comporter en outre la réalisation d'au moins un contact électrique à travers le premier substrat, destiné à former une liaison électrique entre la cavité et une face arrière du premier substrat opposée à une autre face du premier substrat destinée à être disposée en regard du second substrat.

On propose également un procédé de réalisation d'une structure d'encapsulation d'au moins un micro-dispositif, comportant au moins les étapes suivantes :
- réalisation d'une couche d'au moins un matériau getter recouvrant, par exemple totalement ou quasi-totalement, une face principale d'un second substrat,
- solidarisation du second substrat au premier substrat par l'intermédiaire de la couche de matériau getter, délimitant une cavité formée entre le premier substrat et le second substrat et dans laquelle est disposé le micro-dispositif.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 à 3 représentent des structures d'encapsulation de micro-dispositifs, objets de la présente invention, selon différents modes de réalisation,
- les figures 4A à 4E représentent des étapes d'un procédé de réalisation d'une structure d'encapsulation d'au moins un micro-dispositif, également objet de la présente invention, selon un mode de réalisation particulier.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

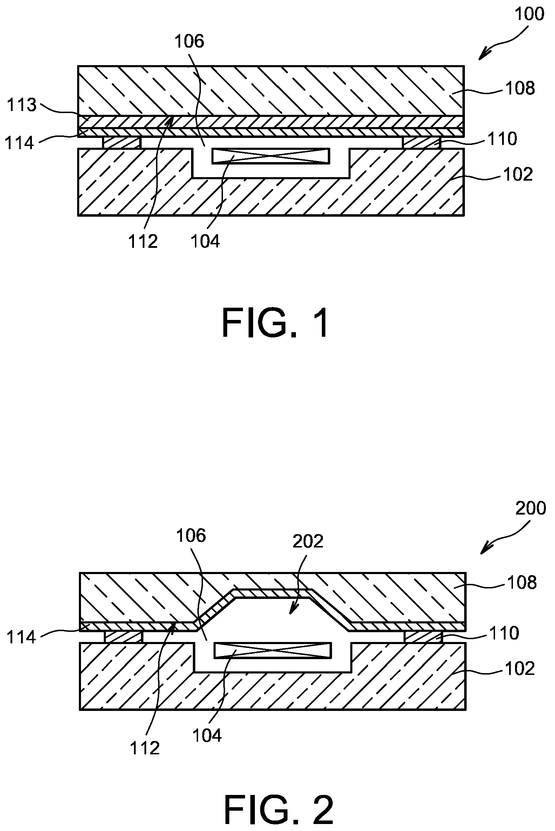

On se réfère à la figure 1 qui représente une structure d'encapsulation 100 selon un premier mode de réalisation.

La structure d'encapsulation 100 comporte un premier substrat 102, comprenant par exemple du semi-conducteur tel que du silicium, dans lequel est réalisé un micro-dispositif 104, par exemple de type MEMS et/ou NEMS ou de type détecteur infrarouge, tel qu'un micro-bolomètre. Le micro-dispositif 104 est encapsulé dans une cavité 106 formée entre le premier substrat 102 servant de support au micro-dispositif 104, et un second substrat 108, comprenant également du semi-conducteur tel que du silicium ou du verre, et formant un capot. Les substrats 102 et 108 sont solidarisés l'un à l'autre par l'intermédiaire d'une interface de collage 110 réalisée sous la forme d'un cordon de scellement. Ce cordon de scellement est par exemple composé d'un ou plusieurs matériaux fusibles.

Une couche d'isolation 113 comprenant par exemple, lorsque le second substrat 108 comporte un matériau semi-conducteur ou électriquement conducteur, de l'oxyde ou du nitrure, est réalisée au niveau d'une face principale 112 du second substrat 108. Cette couche d'isolation 113, obtenue par exemple par oxydation de la face principale 112 du second substrat 108, recouvre totalement cette face principale 112. La couche d'isolation 113 a par exemple une épaisseur comprise entre quelques dizaines à quelques centaines de nanomètres, par exemple entre environ 10 nm et 900 nm. La couche d'isolation 113 est également complètement recouverte par une couche de matériau getter 114, obtenue par exemple par un dépôt pleine plaque sur toute la surface de la couche d'isolation 113. Ainsi, la totalité de la face principale 112 du second substrat 108 disposée en regard du premier substrat 102, c'est-à-dire du côté de la cavité 106, est recouverte par une couche de matériau getter 114, ici par l'intermédiaire de la couche d'isolation 113 formant une isolation électrique entre la couche de matériau getter 114 et le second substrat 108. Le second substrat 108 forme ici un capot continu car il n'est traversé par aucun trou ou ouverture.

Etant donné qu'une face principale 112 du second substrat 108 se trouvant du côté de la cavité 106 est plane et que le micro-dispositif 104 est formé au niveau d'une face principale du premier substrat 102 se trouvant en regard du second substrat 108, la hauteur de la cavité 106, c'est-à-dire la distance entre le premier substrat 102 et la couche de matériau getter 114, est donc définie par l'épaisseur de l'interface de collage 110.

Dans le cas d'un micro-dispositif 104 de type détecteur infrarouge, la détection est réalisée avantageusement à travers le substrat 102 du fait que le matériau getter de la couche 114 peut ne pas laisser passer le rayonnement infrarouge à détecter.

On se réfère à la figure 2 qui représente une structure d'encapsulation 200 selon un deuxième mode de réalisation.

Par rapport à la structure 100 précédemment décrite, un trou, ou creux, 202 est formé dans le second substrat 108, au niveau de la face principale 112 du second substrat 108. Ce creux 202 est formé dans une partie du second substrat 108 destinée à être disposée dans la cavité 106. Ce creux 202 est formé préalablement au dépôt de la couche de matériau getter 114 afin que l'ensemble de la face principale 112 et les parois du creux 202 soient recouvertes par la couche de matériau getter 114. De plus, par rapport à la structure 100 selon le premier mode de réalisation, la structure d'encapsulation 200 ne comporte pas de couche d'isolation disposée entre la face principale 112 du second substrat 108 et la couche de matériau getter 114.

Par rapport au premier mode de réalisation, un tel creux 202 permet d'augmenter le volume de la cavité 106 dans laquelle le micro-dispositif 104 est encapsulé. Ce creux 202 n'est réalisé qu'à travers une partie de l'épaisseur du second substrat 108 qui forme donc un capot continu.

Dans une variante, il serait possible qu'une couche d'isolation, par exemple similaire à la couche d'isolation 113 précédemment décrite, soit disposée entre la couche de matériau getter 114 et le second substrat 108 de la structure d'encapsulation 200.

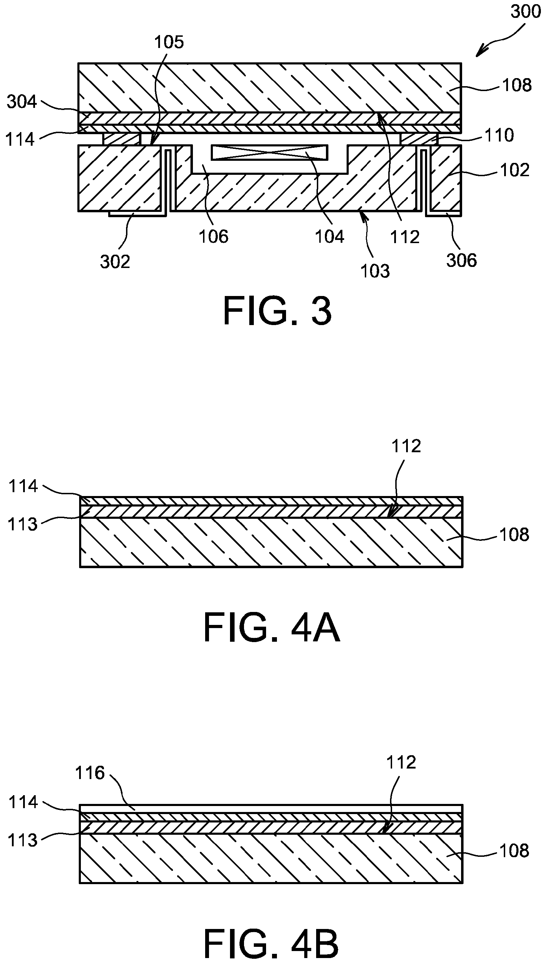

On se réfère à la figure 3 qui représente une structure d'encapsulation 300 selon un troisième mode de réalisation.

Par rapport à la structure 100 précédemment décrite, un via traversant 302 est formé à travers le premier substrat 102, depuis une face arrière 103 du premier substrat 102 opposée à une face avant 105 du premier substrat 102 au niveau de laquelle est réalisé le micro-dispositif 104. Ce via traversant 302 débouche dans la cavité 106 et est relié électriquement au micro-dispositif 104, formant ainsi un accès électrique au micro-dispositif 104 depuis la face arrière 103 du premier substrat 102. Un via 306, relié électriquement au matériau getter 114 via l'interface de collage 110, est réalisé à travers le premier substrat 102, et forme ainsi un accès électrique au matériau getter 114 depuis la face arrière 103 du premier substrat 102. D'autres vias, non représentés et similaires au via 302 ou au via 306, peuvent être formés à travers le premier substrat 102. Un tel via 302 permet réaliser une reprise de contact électrique du micro-dispositif 104 au niveau de la face arrière 103 du premier substrat 102, mais également de réaliser un empilement de la structure d'encapsulation 300 sur un circuit électronique par l'intermédiaire de microbilles à base d'un matériau fusible (« flip-chip »), une partie de ce via 302 pouvant former une surface de mouillage à une microbille de matériau fusible. Il en est de même pour le via 306. Le second substrat 108 forme là encore un capot continu.

La structure d'encapsulation 300 comporte également, entre le second substrat 108 et la couche de matériau getter 114, une couche 304 d'ajustement de la température d'activation thermique du matériau getter de la couche 114. Cette couche 304 est à base d'un ou plusieurs matériaux métalliques, par exemple à base de Cu et/ou de Ni et/ou de Pt et/ou d'Ag et/ou de Ru et/ou de Cr et/ou d'Au et/ou d'Al, et permet de moduler la température à laquelle le matériau getter de la couche 114 réagit avec l'atmosphère de la cavité 106. Ainsi, cette couche 304 permet d'abaisser la température d'activation thermique de ce matériau getter telle qu'elle soit par exemple comprise entre environ 275°C et 425°C en fonction de la nature du métal de la couche d'ajustement 304 et de la nature du matériau getter de la couche 114. L'utilisation d'une telle couche d'ajustement de la température d'activation thermique est possible grâce au fait que c'est la face arrière de la couche de matériau getter 114 qui est disposée contre la couche d'ajustement 304.

L'épaisseur de la couche 304 est par exemple comprise entre environ 50 nm et 500 nm. La couche d'ajustement 304 peut avoir un coefficient de dilatation thermique compris entre environ 5.10⁻⁶/°C et 23.10⁻⁶/°C et un rapport entre sa température d'élaboration (température à laquelle la couche 304 est déposée) et sa température de fusion compris sensiblement entre environ 0,1 et 0,3. La couche d'ajustement 304 est par exemple déposée par évaporation. D'autres caractéristiques relatives à une telle couche 304 d'ajustement de température sont décrites par exemple dans le document WO 2009/087284.

Dans chacune des structures d'encapsulation 100, 200 et 300, la couche de matériau getter 114 recouvre totalement le second substrat 108, par l'intermédiaire ou non d'une ou plusieurs autres couches, et est présente à la fois dans la cavité 106, au niveau du capot, et contre l'interface de collage 110, entre l'interface de collage 110 et le second substrat 108.

On décrit maintenant, en liaison avec les figures 4A à 4E, un exemple d'un procédé de réalisation de la structure d'encapsulation 100 précédemment décrite.

On réalise tout d'abord la couche d'isolation 113 au niveau de l'ensemble de la face principale 112 du second substrat 108. Cette couche d'isolation 113 peut être obtenue par une oxydation, par exemple une oxydation thermique, ou une nitruration du second substrat 108 au niveau de sa face principale 112, et a par exemple une épaisseur comprise entre environ quelques dizaines de nanomètres et quelques centaines de nanomètres.

La couche de matériau getter 114 est ensuite formée par un dépôt pleine plaque contre la couche d'isolation 113, afin que la totalité de la face principale 112 du second substrat 108 soit recouverte par la couche de matériau getter 114 par l'intermédiaire de la couche d'isolation 113 (figure 4A). L'épaisseur de la couche de matériau getter 114 est par exemple comprise entre environ 100 nm et 2 µm.

En option, on peut former par voie sèche, sur la couche de matériau getter 114, une couche de protection 116 à base d'oxyde ou de nitrure du matériau getter de la couche 114 (figure 4B). Cette couche de protection 116 peut être obtenue par une oxydation ou une nitruration mise en oeuvre sous atmosphère sèche de dioxygène et/ou de diazote. On entend par « atmosphère sèche de dioxygène et/ou de diazote » une atmosphère sous pression partielle faible ou nulle de vapeur d'eau (par exemple inférieure à environ 10⁻⁵ mbar).

Une telle couche de protection 116 peut absorber et/ou adsorber de façon réversible des molécules gazeuses, par exemple celles de l'air ambiant, protégeant ainsi toute la surface du matériau getter de la couche 114 de toute altération par ces molécules gazeuses. Les molécules absorbées et/ou adsorbées par la couche de protection 116 pourront être désorbées par la mise en oeuvre ultérieure d'un simple dégazage. Il est donc possible d'exposer par la suite le matériau getter à l'air ambiant sans que celui-ci ne soit altéré par les gaz de l'air ambiant.

Par rapport à une oxydation du matériau getter se produisant en exposant le matériau getter à l'air ambiant, l'oxydation et/ou la nitruration réalisées par voie sèche, c'est-à-dire réalisées dans un environnement clos comportant de l'oxygène sec et/ou du diazote sec, ne diffusent pas de molécules d'hydrogène dans le matériau getter. Ainsi, aucun dégazage pour éliminer spécifiquement ces molécules d'hydrogène n'est nécessaire avant de former la cavité 106.

Cette couche de protection 116 permet également d'augmenter la capacité de pompage du matériau getter de la couche 114 par rapport à un matériau getter non protégé et exposé à l'air ambiant. Enfin, le matériau getter ainsi protégé peut être activé thermiquement à partir d'une température d'activation plus basse, par exemple inférieure d'environ 20°C à 30°C, que la température d'activation d'un matériau getter non protégé et exposé à l'air ambiant. La réalisation de la couche de protection 116 est par exemple mise en oeuvre à une température comprise entre environ 50°C et 120°C, à une pression par exemple au minimum égale à environ 10⁻² mbar, pendant une durée de quelques minutes, par exemple comprise entre environ 1 mn et 10 mn. On obtient une couche de protection 116 dont l'épaisseur est d'environ quelques nanomètres, par exemple comprise entre environ 1 nm et 10 nm.

Une couche de protection 116 comportant du chrome peut aussi être envisagée. En effet, le chrome possède la propension à se passiver naturellement à l'air ambiant par formation d'une couche d'oxyde de chrome. Le dépôt d'une couche de protection de chrome d'une épaisseur comprise entre environ 10 nm et 50 nm conduit à l'obtention d'une microstructure très colonnaire ainsi apte à la diffusion du getter 114 au travers des joints de grains de la couche de chrome. Cette diffusion est de plus favorisée d'un point de vue thermodynamique.

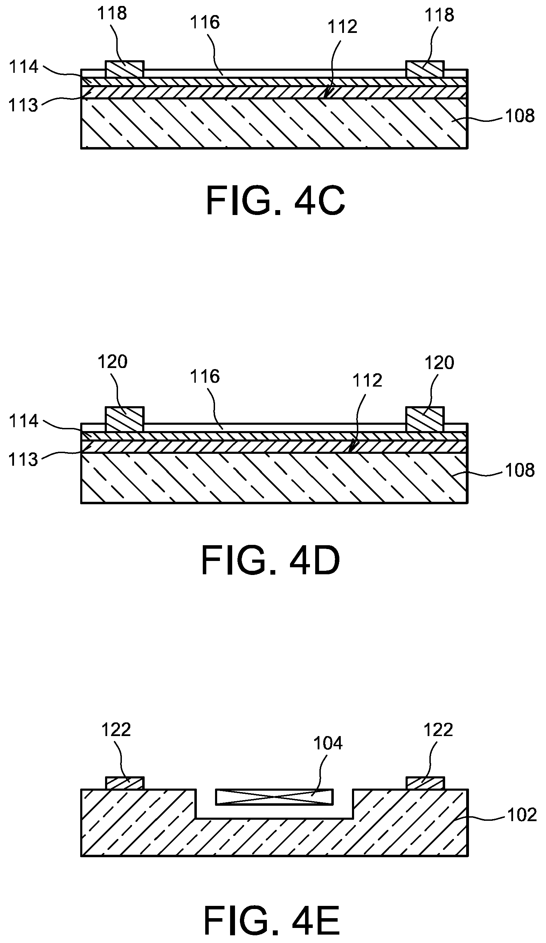

Comme représenté sur la figure 4C, on réalise ensuite, sur la couche 114 de matériau getter, des portions 118 de matériau, par exemple un matériau métallique, qui favoriseront par la suite la croissance du matériau destiné à former le cordon de scellement, c'est-à-dire l'interface de collage entre le premier substrat 102 et le second substrat 108.

Pour cela, on réalise tout d'abord une photolithographie de la couche de protection 116 définissant les emplacements des portions de matériau 118, selon la délimitation souhaitée de la cavité 106. Un masque à base de résine, non représenté, dont le motif correspond à celui du cordon de scellement, est donc réalisé sur la couche de protection 116. On réalise ensuite un décapage de la couche de protection 116 par une gravure, par exemple par faisceaux ioniques (gravure IBE), au niveau des emplacements précédemment définis pour la formation des portions 118.

On réalise ensuite un dépôt d'une barrière de diffusion au niveau des emplacements des portions 118, par exemple sous la forme d'une couche à base de nickel ou de nitrure de tungstène. Lorsque la couche barrière comporte du nitrure de tungstène, l'épaisseur de cette couche peut être de quelques dizaines de nanomètres, et par exemple comprise entre environ 10 nm et 100 nm. Lorsque la couche barrière comporte du nickel, l'épaisseur de cette couche peut être de quelques centaines de nanomètres, et par exemple comprise entre environ 100 nm et 1 µm.

On réalise ensuite un dépôt PVD (dépôt physique en phase vapeur) du matériau des portions 118, par exemple de l'or, sur une épaisseur de quelques dizaines de nanomètres, par exemple comprise entre environ 10 nm et 100 nm, aux emplacements définis par la précédente étape de photolithographie, en vue de favoriser la croissance ultérieure du matériau du cordon de scellement (figure 4C). L'épaisseur du masque de résine réalisé pour mettre en oeuvre la précédente étape de photolithographie est dimensionnée pour que les flancs des ouvertures dans ce masque ne soient pas recouverts du matériau des portions 118. Pour cela, le masque de résine a par exemple une épaisseur de quelques microns, par exemple égale à environ 10 µm. Il est possible que deux étapes successives de photolithographie soient mises en oeuvre : une première pour décaper la couche de protection 116, et une seconde pour graver la couche barrière et l'or afin de ne conserver que les portions 118.

Un dépôt électrolytique, par exemple de type ECD (dépôt électrochimique) du matériau destiné à former le cordon de scellement est ensuite réalisé sur la barrière de diffusion, au niveau des emplacements définis par les portions 118 de matériau. Ce matériau déposé électrolytiquement se confond avec celui des portions 118, formant des portions 120 de matériau métallique qui serviront à réaliser le cordon de scellement (figure 4D). Le métal des portions 120 peut être de l'or. La couche 114 de matériau getter est utilisée comme couche d'amenée de courant pour réaliser la croissance de ce dépôt électrolytique.

La présence de la couche de protection 116 est avantageuse lors de la mise en oeuvre d'un tel dépôt électrolytique car la surface de la couche de protection 116 est non mouillante vis-à-vis de l'alliage Au-Sn 29% at. déposé électrolytiquement. Ainsi, cet alliage ne s'étale pas sur la surface de la couche de protection 116 et reste confiné sur les zones définies par les portions 118.

Il est également possible que le matériau des portions 120 soit un alliage Au-Sn 29% at. (comportant 71% atomique d'or et 29% atomique d'étain). Dans ce cas, la présence de la couche barrière sous ce matériau permet d'éviter une réactivité de ce matériau avec le matériau getter de la couche 114. Il est toutefois possible de déposer cet alliage Au-Sn 29% at. en l'absence de la couche barrière. Dans ce cas, il est préférable de déposer tout d'abord l'or, puis déposer l'étain, l'épaisseur de l'or déposé étant choisie de façon à ce qu'il ne fonde pas complètement lors de l'assemblage du premier substrat 102 avec le second substrat 108.

Lorsque la couche de protection 116 comporte du chrome, il est possible que les portions 118 puis les portions 120 soient réalisées sur la couche de protection 116, sans que des emplacements soient gravés dans la couche de protection 116.

Après le dépôt électrolytique des portions 120, le masque de résine ayant servi à ce dépôt est éliminé, par exemple par l'intermédiaire d'un solvant ou tout produit adapté.

Parallèlement aux étapes précédemment décrites en liaison avec les figures 4A à 4D, on forme le micro-dispositif 104 dans le premier substrat 102. Des secondes portions métalliques 122, par exemple à base du même métal ou du même alliage que celui des portions 120, sont réalisées sur la face du premier substrat 102 destinée à être disposée en regard du second substrat 102. Ces secondes portions 122 sont réalisées selon le même motif que celui des portions 120 (figure 4E).

Dans une variante, il est possible que ces secondes portions 122 comportent non pas un matériau électriquement conducteur comme décrit précédemment, mais comportent un matériau diélectrique, par exemple de l'oxyde ou du nitrure de semi-conducteur tel que du silicium. Dans ce cas, les secondes portions 122 peuvent être thermocompressées directement contre la couche de matériau getter 114 (les portions 120 précédemment décrites peuvent ne pas être réalisées sur la couche de matériau getter 114).

Enfin, les deux substrats 102 et 108 sont assemblés et solidarisés l'un à l'autre en réalisant une thermocompression des secondes portions métalliques 122 contre les portions métalliques 120, formant ainsi le cordon de scellement 110. Ce scellement peut être réalisé sous atmosphère contrôlée afin de retrouver cette atmosphère contrôlée (par exemple du vide ou sous atmosphère gazeuse particulière) dans la cavité 106 dans laquelle est encapsulé le micro-dispositif 104.

Les portions 120 et 122 peuvent être directement thermocompressées l'une contre l'autre. Toutefois, il est également possible qu'au moins un matériau fusible soit disposé entre les portions 120 et 122 et que la thermocompression soit réalisée entre les portions 120, 122 par l'intermédiaire de ce matériau fusible.

L'encapsulation est ensuite achevée en réalisant une activation thermique du matériau getter de la couche 114 par un recuit à une température par exemple comprise entre environ 200°C et 450°C et choisie en fonction de la nature du matériau getter. Outre l'activation thermique de la couche de matériau getter 114, ce recuit permet également de « dissoudre » la couche de protection 116, c'est-à-dire de supprimer la couche de protection 116, les molécules d'oxygène et/ou d'azote présentes dans la couche de protection 116 sous la forme de particules d'oxyde et/ou de nitrure étant alors absorbées par l'ensemble du matériau getter 114, ce qui permet de retrouver un matériau getter 114 uniforme, ici à base de titane.

Lorsque les portions 122 sont à base d'un matériau diélectrique et sont solidarisées directement contre le matériau getter, cette activation thermique contribue à créer une liaison getter / diélectrique.

Dans une variante de ce procédé de réalisation, il est possible de ne pas réaliser la couche de protection 116. Dans ce cas, une couche à base du matériau des portions 118, ici de l'or, d'épaisseur égale à quelques dizaines de nanomètres (par exemple comprise entre environ 10 nm et 100 nm) est déposée directement sur la couche de matériau getter 114. Dans ce cas, après l'étape de photolithographie définissant les emplacements des portions 118, on réalise directement le dépôt électrolytique afin de former les portions métalliques 120. On grave alors par voie sèche ou humide les portions de la couche d'or se trouvant autour des portions 120 afin de révéler la couche de matériau getter 114. Dans cette variante, il peut aussi être ajoutée une barrière de diffusion telle que celle décrite précédemment entre le getter et la couche d'or. Il sera alors nécessaire de dégager le getter 114 par gravure de l'or puis de la barrière de diffusion autour des portions 120. Le procédé est alors achevé par le scellement des deux substrats 102 et 108 par une thermocompression des portions métalliques 120 contre les portions métalliques 122.

La structure 200 précédemment décrite peut être obtenue en mettant en oeuvre des étapes sensiblement similaires à celles décrites ci-dessus pour la réalisation de la structure 100, excepté que l'on réalise, préalablement au dépôt de la couche de matériau getter 114 et éventuellement préalablement à la couche d'oxydation 112, le trou 202 dans le second substrat 108, par exemple par gravure.

La structure 300 précédemment décrite peut être obtenue en mettant en oeuvre des étapes sensiblement similaires à celles décrites ci-dessus pour la réalisation de la structure 100, excepté que l'on réalise ensuite les vias 302 et 306 après avoir solidarisé le premier substrat 102 au second substrat 108. Par exemple, le via 302 est obtenu en réalisant d'abord une photolithographie d'un masque de résine et une gravure DRIE (gravure ionique réactive profonde) du silicium du substrat 102 avec arrêt sur une ligne métallique du substrat 102 qui est reliée au microdispositif 104. On réalise ensuite une isolation des vias 302 et 306 par une oxydation, par exemple de type CVD (dépôt chimique en phase vapeur), des parois gravées dans le substrat 102. On réalise alors un décapage du fond du via par une gravure adaptée. Des couches métalliques servant de fond continu pour un futur dépôt électrochimique dans le via, sont déposées, par exemple par des dépôts de type physique en phase vapeur (par exemple : dépôt d'une couche de titane puis dépôt d'une couche de cuivre). Une photolithographie sur la face arrière 103 est ensuite réalisée pour une croissance électrochimique de lignes de cuivre. Enfin, le fond continu précédemment réalisé est gravé.

## Revendications

1. Structure d'encapsulation (100, 200, 300) comportant au moins une cavité (106) dans laquelle est disposé au moins un micro-dispositif (104), la cavité (106) étant délimitée par au moins un premier substrat (102) et au moins un second substrat (108) reporté et solidarisé au premier substrat (102) par l'intermédiaire d'au moins une interface de collage (110) composée d'au moins un matériau métallique ou diélectrique, dans laquelle au moins une face principale (112) du second substrat (108) disposée en regard du premier substrat (102) est recouverte par au moins une couche d'au moins un matériau getter (114), l'interface de collage (110) étant disposée entre le premier substrat (102) et la couche de matériau getter (114), le second substrat (108) comportant une épaisseur supérieure ou égale à environ 50 *µ*m et formant un capot continu.

2. Structure d'encapsulation (100, 200, 300) selon la revendication 1, dans laquelle la cavité (106) est fermée hermétiquement.

3. Structure d'encapsulation (100, 200, 300) selon l'une des revendications précédentes, dans laquelle la couche de matériau getter (114) a une épaisseur comprise entre environ 100 nm et 2 *µ*m.

4. Structure d'encapsulation (100, 200, 300) selon l'une des revendications précédentes, dans laquelle l'interface de collage (110) comporte au moins deux portions métalliques (120, 122) thermocompressées l'une contre l'autre.

5. Structure d'encapsulation (100, 200, 300) selon l'une des revendications 1 à 3, dans laquelle l'interface de collage (110) comporte au moins une portion diélectrique (122) thermocompressée contre la couche de matériau getter (114) ou contre au moins une portion métallique (120) disposée sur la couche de matériau getter (114).

6. Structure d'encapsulation (100, 200, 300) selon l'une des revendications précédentes, dans laquelle le micro-dispositif (104) est réalisé dans et/ou sur le premier substrat (102).

7. Structure d'encapsulation (300) selon l'une des revendications précédentes, comportant en outre au moins une couche (304) d'un matériau apte à modifier la température d'activation thermique du matériau getter (114), disposée entre la couche de matériau getter (114) et ladite face principale (112) du second substrat (108).

8. Structure d'encapsulation (200) selon l'une des revendications précédentes, dans laquelle le second substrat (108) comporte au moins un creux (202) formé au niveau de ladite face principale (112) du second substrat (108) et délimitant au moins une paroi de la cavité (106).

9. Structure d'encapsulation (300) selon l'une des revendications précédentes, comportant en outre au moins un contact électrique (302, 306) réalisé à travers le premier substrat (102), formant une liaison électrique entre la cavité (106) et une face arrière (103) du premier substrat (102) opposée à une autre face (105) du premier substrat (102) disposée en regard du second substrat (108), et/ou une liaison électrique entre la face arrière (103) du premier substrat (102) et le matériau getter (114) via l'interface de collage (110).

10. Procédé de réalisation d'une structure d'encapsulation (100, 200, 300) d'au moins un micro-dispositif (104), comportant au moins les étapes suivantes :
- réalisation d' une couche d'au moins un matériau getter (114) recouvrant une face principale (112) d'un second substrat (108) comportant une épaisseur supérieure ou égale à environ 50 *µ*m,
- réalisation d'une interface de collage (110) composée d'au moins un matériau métallique ou diélectrique sur un premier substrat (102) et/ou sur la couche de matériau getter (114),
- report et solidarisation du second substrat (108) au premier substrat (102) par l'intermédiaire de l'interface de collage (110), délimitant une cavité (106) formée entre le premier substrat (102) et le second substrat (108) et dans laquelle est disposé le micro-dispositif (104), l'interface de collage (110) étant disposée entre le premier substrat (102) et la couche de matériau getter (114), le second substrat (108) formant un capot continu.

11. Procédé selon la revendication 10, dans lequel la solidarisation est réalisée sous atmosphère contrôlée et telle que la cavité (106) soit fermée hermétiquement.

12. Procédé selon l'une des revendications 10 ou 11, dans lequel l'interface de collage (110) est réalisée en formant au moins une première portion métallique (120) sur la couche de matériau getter (114) et/ou au moins une seconde portion métallique ou diélectrique (122) sur le premier substrat (102), et dans lequel la solidarisation du second substrat (108) au premier substrat (102) est obtenue par la mise en oeuvre d'une thcrmocompression de la première portion métallique (120) contre la seconde portion métallique ou diélectrique (122) ou de la seconde portion métallique ou diélectrique (122) contre la couche de matériau getter (114).

13. Procédé selon la revendication 12, dans lequel la première portion métallique (120) est réalisée par un dépôt électrolytique d' au moins un matériau métallique sur la couche de matériau getter (114) au cours duquel un courant apte à faire croître ledit matériau métallique circule dans la couche de matériau getter (114).

14. Procédé selon l'une des revendications 10 à 13, comportant en outre, préalablement à la réalisation de la couche de matériau getter (114), une étape de réalisation d'une couche (304) d'un matériau apte à modifier la température d'activation thermique du matériau getter (114) sur ladite face principale (112) du second substrat (108), la couche de matériau getter (114) étant ensuite réalisée au moins sur ladite couche du matériau (304) apte à modifier la température d'activation thermique du matériau getter (114).

15. Procédé selon l'une des revendications 10 à 14, comportant en outre, préalablement à la réalisation de la couche de matériau getter (114), une étape de réalisation d'au moins un creux (202) au niveau de ladite face principale (112) du second substrat (108) et délimitant au moins une paroi de la cavité (106).

16. Procédé selon l'une des revendications 10 à 15, comportant en outre, préalablement à la solidarisation du second substrat (108) au premier substrat (102), une étape de réalisation du micro-dispositif (104) dans et/ou sur le premier substrat (102).

17. Procédé selon l'une des revendications 10 à 16, comportant en outre la réalisation d'au moins un contact électrique (302) à travers le premier substrat (102), destiné à former une liaison électrique entre la cavité (106) et une face arrière (103) du premier substrat (102) opposée à une autre face (105) du premier substrat (102) destinée à être disposée en regard du second substrat (108).

## Patentansprüche

1. Einkapselungsstruktur (100, 200, 300), enthaltend zumindest einen Hohlraum (106), in welchem zumindest eine Mikrovorrichtung (104) angeordnet ist, wobei der Hohlraum (106) von zumindest einem ersten Substrat (102) und zumindest einem zweiten Substrat (108) eingegrenzt wird, das versetzt und mit dem ersten Substrat (102) durch zumindest eine Klebeschnittstelle (110) fest verbunden ist, die aus zumindest einem metallischen bzw. dielektrischen Material zusammengesetzt ist, wobei zumindest eine dem ersten Substrat (102) gegenüberliegende Hauptfläche (112) des zweiten Substrats (108) mit zumindest einer Schicht aus zumindest einem Getter-Material (114) bedeckt ist, wobei die Klebeschnittstelle (110) zwischen dem ersten Substrat (102) und der Schicht aus Getter-Material (114) angeordnet ist, wobei das zweite Substrat (108) eine Dicke größer oder gleich etwa 50 µm aufweist und eine durchgehende Abdeckung bildet.

2. Einkapselungsstruktur (100, 200, 300) nach Anspruch 1, wobei der Hohlraum (106) hermetisch verschlossen ist.

3. Einkapselungsstruktur (100, 200, 300) nach einem der vorangehenden Ansprüche, wobei die Schicht aus Getter-Material (114) eine Dicke zwischen etwa 100 nm und 2 µm hat.

4. Einkapselungsstruktur (100, 200, 300) nach einem der vorangehenden Ansprüche, wobei die Klebeschnittstelle (110) zumindest zwei metallische Abschnitte (120, 122) aufweist, die aneinander thermokomprimiert sind.

5. Einkapselungsstruktur (100, 200, 300) nach einem der Ansprüche 1 bis 3, wobei die Klebeschnittstelle (110) zumindest einen dielektrischen Abschnitt (122) aufweist, der an die Schicht aus Getter-Material (114) oder an den zumindest einen metallischen Abschnitt (120) thermokomprimiert ist, der an der Schicht aus Getter-Material (114) angeordnet ist.

6. Einkapselungsstruktur (100, 200, 300) nach einem der vorangehenden Ansprüche, wobei die Mikrovorrichtung (104) in und/oder an dem ersten Substrat (102) ausgebildet ist.

7. Einkapselungsstruktur (300) nach einem der vorangehenden Ansprüche, ferner enthaltend zumindest eine Schicht (304) aus einem Material, das dazu geeignet ist, die Temperatur der thermischen Aktivierung des Getter-Materials (114) zu verändern, welche zwischen der Schicht aus Getter-Material (114) und der Hauptfläche (112) des zweiten Substrats (108) angeordnet ist.

8. Einkapselungsstruktur (200) nach einem der vorangehenden Ansprüche, wobei das zweite Substrat (108) zumindest eine Vertiefung (202) aufweist, die im Bereich der Hauptfläche (112) des zweiten Substrats (108) gebildet ist und zumindest eine Wandung des Hohlraums (106) begrenzt.

9. Einkapselungsstruktur (300) nach einem der vorangehenden Ansprüche, ferner enthaltend zumindest ein elektrisches Kontaktstück (302, 306), das durch das erste Substrat (102) hindurch ausgebildet ist und eine elektrische Verbindung zwischen dem Hohlraum (106) und einer Hinterseite (103) des ersten Substrats (102) bildet, die einer weiteren Seite (105) des ersten Substrats (102) entgegengesetzt ist, die dem zweiten Substrat (108) gegenüberlieget, und/oder eine elektrische Verbindung zwischen der Hinterseite (103) des ersten Substrats (102) und dem Getter-Material (114) über die Klebeschnittstelle (110) bildet.

10. Verfahren zum Herstellen einer Einkapselungsstruktur (100, 200, 300) für zumindest eine Mikrovorrichtung (104), das zumindest die nachfolgenden Schritte umfasst:
- Herstellen einer Schicht aus zumindest einem Getter-Material (114), das eine Hauptfläche (112) eines zweiten Substrats (108) überdeckt und eine Dicke größer oder gleich etwa 50 µm aufweist,
- Herstellen einer Klebeschnittstelle (110), die aus zumindest einem metallischen bzw. dielektrischen Material besteht, auf einem ersten Substrat (102) und/oder auf der Schicht aus Getter-Material (114),
- Versetzen und festes Verbinden des zweiten Substrats (108) mit dem ersten Substrat (102) durch die Klebeschnittstelle (110), die einen Hohlraum (106) eingrenzt, der zwischen dem ersten Substrat (102) und dem zweiten Substrat (108) ausgebildet ist und in dem die Mikrovorrichtung (104) angeordnet ist, wobei die Klebeschnittstelle (110) zwischen dem ersten Substrat (102) und der Schicht aus Getter-Material (114) angeordnet ist, wobei das zweite Substrat (108) eine durchgehende Abdeckung bildet.

11. Verfahren nach Anspruch 10, wobei die feste Verbindung unter kontrollierter Atmosphäre und derart erfolgt, dass der Hohlraum (106) hermetisch verschlossen wird.

12. Verfahren nach einem der Ansprüche 10 oder 11, wobei die Klebeschnittstelle (110) durch Bilden von zumindest einem ersten metallischen Abschnitt (120) auf der Schicht aus Getter-Material (114) und/oder zumindest eines zweiten metallischen bzw. dielektrischen Abschnitts (122) auf dem ersten Substrat (102) ausgebildet ist, und wobei die feste Verbindung des zweiten Substrats (108) mit dem ersten Substrat (102) durch Ausführen einer Thermokompression des ersten metallischen Abschnitts (120) mit dem zweiten metallischen bzw. dielektrischen Abschnitt (122) oder des zweiten metallischen bzw. dielektrischen Abschnitts (122) mit der Schicht aus Getter-Material (114) erhalten wird.

13. Verfahren nach Anspruch 12, wobei der erste metallische Abschnitt (120) durch elektrolytische Abscheidung zumindest eines metallischen Materials auf der Schicht aus Getter-Material (114) ausgebildet wird, während dessen ein Strom, der geeignet ist, das metallische Material wachsen zu lassen, in der Schicht aus Getter-Material (114) fließt.

14. Verfahren nach einem der Ansprüche 10 bis 13, ferner umfassend vor dem Herstellen der Schicht aus Getter-Material (114) einen Schritt des Herstellens einer Schicht (304) aus einem Material, das dazu geeignet ist, die Temperatur der thermischen Aktivierung des Getter-Materials (114) auf der Hauptfläche (112) des zweiten Substrats (108) zu verändern, wobei die Schicht aus Getter-Material (114) dann zumindest auf der Materialschicht (304) ausgebildet wird, die dazu geeignet ist, die Temperatur der thermischen Aktivierung des Getter-Materials (114) zu verändern.

15. Verfahren nach einem der Ansprüche 10 bis 14, ferner umfassend vor dem Herstellen der Schicht aus Getter-Material (114) einen Schritt des Herstellens von zumindest einer Vertiefung (202) im Bereich der Hauptfläche (112) des zweiten Substrats (108), welche zumindest eine Wandung des Hohlraums (106) begrenzt.

16. Verfahren nach einem der Ansprüche 10 bis 15, ferner umfassend vor dem festen Verbinden des zweiten Substrats (108) mit dem ersten Substrat (102) einen Schritt des Herstellens der Mikrovorrichtung (104) in und/oder an dem ersten Substrat (102).

17. Verfahren nach einem der Ansprüche 10 bis 16, ferner umfassend das Herstellen von zumindest einem elektrischen Kontaktstück (302) durch das erste Substrat (102) hindurch, das dazu bestimmt ist, eine elektrische Verbindung zwischen dem Hohlraum (106) und einer Hinterseite (103) des ersten Substrats (102) zu bilden, die einer weiteren Seite (105) des ersten Substrats (102) entgegengesetzt ist, die dazu bestimmt ist, dem zweiten Substrat (108) gegenüberliegend angeordnet zu werden.

## Claims

1. Packaging structure (100, 200, 300) including at least one cavity (106) wherein at least one micro-device (104) is provided, the cavity (106) being bounded by at least a first substrate (102) and at least a second substrate (108) integral with the first substrate (102) through at least one bonding interface (110) comprising at least one metal or dielectric material, wherein at least one main face (112) of the second substrate (108) arranged facing the first substrate (102) is covered with at least one layer of at least one getter material (114), the bonding interface (110) being arranged between the first substrate (102) and the layer of getter material (114), the thickness of the second substrate (108) being higher than or equal to around 50 µm and forming a continuous cover.

2. Packaging structure (100, 200, 300) according to claim 1, wherein the cavity (106) is hermetically sealed.

3. Packaging structure (100, 200, 300) according to one of previous claims, wherein the layer of getter material (114) has a thickness between about 100 nm and 2 µm.

4. Packaging structure (100, 200, 300) according to one of previous claims, wherein the bonding interface (110) includes at least two metal portions (120, 122) heat-compressed against each other.

5. Packaging structure (100, 200, 300) according to one of claims 1 to 3, wherein the bonding interface (110) includes at least one dielectric portion (122) heat-compressed against the layer of getter material (114) or against at least one metal portion (120) arranged on the layer of getter material (114).

6. Packaging structure (100, 200, 300) according to one of previous claims, wherein the micro-device (104) is made in and/or on the first substrate (102).

7. Packaging structure (300) according to one of previous claims, further including at least one layer (304) of a material capable of changing the thermal activation temperature of the getter material (114), which layer is provided between the layer of getter material (114) and said main face (112) of the second substrate (108).

8. Packaging structure (200) according to one of previous claims, wherein the second substrate (108) includes at least one trough (202) formed at said main face (112) of the second substrate (108) and bounding at least a wall of the cavity (106).

9. Packaging structure (300) according to one of previous claims, further including at least one electrical contact (302, 306) made through the first substrate (102), forming an electrical connection between the cavity (106) and a back face (103) of the first substrate (102) opposed to another face (105) of the first substrate (102) arranged facing the second substrate (108) and/or an electrical connection between the back face (103) of the first substrate (102) and the getter material (114) via the bonding interface (110).

10. Method for making a packaging structure (100, 200, 300) of at least one micro-device (104), including at least the following steps of:
- making a layer of at least one getter material (114) covering a main face (112) of a second substrate (108) having a thickness higher than or equal to around 50 µm,
- making a bonding interface (110) comprising at least one metal or dielectric material on a first substrate (102) and/or on the layer of getter material (114),
- making the second substrate (108) integral with the first substrate (102) through the bonding interface (110), bounding a cavity (106) formed between the first substrate (102) and the second substrate (108), and in which the micro-device (104) is provided, the bonding interface (110) being provided between the first substrate (102) and the layer of getter material (114), the second substrate (108) forming a continuous cover.

11. Method according to claim 10, wherein the step of making substrates integral is carried out under a controlled atmosphere and such that the cavity (106) is hermetically sealed.

12. Method according to one of claims 11 or 11, wherein the bonding interface (110) is made by forming at least a first metal portion (120) on the layer of getter material (114) and/or at least a second metal or dielectric portion (122) on the first substrate (102), and wherein the step of making the second substrate (108) integral with the first substrate (102) is achieved by implementing a heat compression of the first metal portion (120) against the second metal or dielectric portion (122) or the second metal or dielectric portion (122) against the layer of getter material (114).

13. Method according to claim 12, wherein the first metal portion (120) is made by electrolytical deposition of at least one metal material on the layer of getter material (114) during which a current capable of growing said metal material flows in the layer of getter material (114).

14. Method according to one of claims 10 to 13, further including, prior to making the layer of getter material (114), a step of making a layer (304) of a material capable of changing the thermal activation temperature of the getter material (114) on said main face (112) of the second substrate (108), the layer of getter material (114) being then made at least on said layer of material (304) capable of changing the thermal activation temperature of the getter material (114).

15. Method according to one of claims 10 to 14, further including, prior to making the layer of getter material (114), a step of making at least one trough (202) at said main face (112) of the second substrate (108) and bounding at least one wall of the cavity (106).

16. Method according to one of claims 10 to 15, further including, prior to making the second substrate (108) integral with the first substrate (102), a step of making the micro-device (104) in and/or on the first substrate (102).

17. Method according to one of claims 10 to 16, further including making at least one electrical contact (302) through the first substrate (102), intended to form an electrical connection between the cavity (106) and a back face (103) of the first substrate (102) opposed to another face (105) of the first substrate (102) intended to be provided facing the second substrate (108).
